# EUROPÄISCHE PATENTSCHRIFT

(11) **EP 2 399 438 B1**
(45) Veröffentlichungstag und Bekanntmachung des Hinweises auf die Patenterteilung: **25.11.2015**
(21) Anmeldenummer: 10705295.3
(22) Anmeldetag: 17.02.2010
(51) Int. Cl.: H05K 7/14

(54) **SCHALTSCHRANK ODER RACK**
SWITCHGEAR CABINET OR RACK
ARMOIRE DE COMMANDE OU BAIE

(30) Priorität: 19.02.2009 DE 102009009641
(43) Veröffentlichungstag der Anmeldung: 28.12.2011
(73) Patentinhaber: Rittal GmbH & Co. KG, 35745 Herborn (DE)
(72) Erfinder: THIELMANN, Bodo, 35768 Siegbach (DE); HAIN, Markus, 35684 Dillenburg (DE); SCHMIDT, Volker, 57076 Siegen (DE)
(74) Vertreter: Angerhausen, Christoph
(86) Internationale Anmeldenummer: PCT/EP2010/000981
(87) Internationale Veröffentlichungsnummer: WO 2010/094459

(56) Entgegenhaltungen:
- WO-A1-2009/091888
- DE-A1-102007 034 437
- US-A1- 2004 172 155
- US-A1- 2008 265 722

## Beschreibung

Die Erfindung bezieht sich auf einen Schaltschrank oder Rack mit einer Montageeinrichtung, die einen Einbauraum für anwenderseitige Einbaueinheiten frontseitig seitlich begrenzende vertikale Montageprofile mit Befestigungsabschnitten zum Anbringen von Montageabschnitten der Einbaueinheiten aufweist, und mit Komponenten einer Erfassungseinrichtung zum Feststellen, ob an einer Einbauposition des Einbauraums eine Einbaueinheit vorhanden ist oder nicht, wobei die Komponenten der Erfassungseinrichtung eine an einem Montageprofil angebrachte vertikal verlaufende Detektorleiste mit darauf oder darin angeordneten, den Einbaupositionen zugeordneten Detektorelementen und an den Einbaueinheiten angeordneten Transponderelementen aufweisen, deren Information über die Detektorelemente zur Auswertung an eine Überwachungs- und Steuerungseinrichtung drahtlos oder drahtgebunden übertragbar ist. Weiterhin sind an oder in der Detektorleiste Leuchtelemente angebracht, die den Einbaupositionen zugeordnet sind.

Ein derartiger Schaltschrank bzw. derartiges Rack ist in der DE 10 2007 034 437 A1 angegeben. Bei diesem bekannten Schaltschrank ist eine Vorrichtung zum Erkennen von darin aufgenommenen Einbaueinheiten mit einer Erfassungseinheit ausgerüstet, die an eine Auswerte- oder Registriereinrichtung angeschlossen oder anschließbar ist. Die Erfassungseinheit weist dabei in einer Ausgestaltung eine in der Montageebene der Einbaueinheiten angeordnete, an einem Rahmenschenkel oder Montageteil angeschraubte oder aufgeklebte Detektorleiste mit im Raster von einer oder mehreren Höheneinheiten positionierten, berührungslos ansprechenden Antennenelementen und an den Einbaueinheiten angeordnete Transponder, insbesondere RFID-Tags auf. Die leistenförmige Antennenanordnung kann sich dabei aus mehreren mit Stecker-/Kupplungseinheiten zusammengesteckten Antennenmodulen zusammensetzen, die jeweils ein schmales, sich längs erstreckendes, leistenartiges Kunststoffgehäuse zur Abdeckung mehrerer Höheneinheiten aufweisen. Das Gehäuse, das sich auch über die gesamte Höhe des Aufnahmebereichs für die Einbaueinheiten erstrecken kann, besitzt Befestigungsmöglichkeiten zum Anbringen z. B. an einer vertikalen Montageschiene, an der auch die Einbaueinheiten festgelegt sind. Die Transponder bzw. RFID-Tags sind im vorderen Bereich der Einbaueinheiten, insbesondere Servereinheiten, an deren Gehäuse nahe der Detektorleiste positioniert, so dass die Antennenelemente im Nahfeld der jeweils zugeordneten Transponder deren Information auslesen, die über eine Datenleitung oder alternativ drahtlos zu der Auswerte- und Registriereinrichtung übertragen wird. Das jeweilige RFID-Tag besitzt eine eindeutige Identifikation und kennzeichnet die zu erfassende Einbaueinheit, die über die betreffenden Antennenelemente unter Steuerung durch eine Steuereinheit ausgelesen und mit der zugehörigen Höhenposition an die Auswerteeinheit übermittelt wird. Die Befestigung der RFID-Tags an der Einbaueinheit erfolgt durch Kleben oder Schrauben. Die eindeutige Identifikation des so aufgebauten passiven Transponders bzw. RFID-Tags erfolgt bereits im Herstellungswerk.

Die US 2008/265722 A1 zeigt einen Schaltschrank oder ein Rack mit einer Montageeinheit und in einem Einbauraum eingebauten Einbaueinheiten. Zum Erkennen eingebauter Einbaueinheiten ist eine Erfassungseinrichtung mit vertikal an einem Montageprofil angeordneten Sensorelementen und an seitlichen Montageabschnitten der Einbaueinheiten angeordneten RFID-Elementen vorgesehen.

Zwar ergibt die Anordnung der Detektorleiste im Bereich der Einbauebene des Schaltschranks oder Racks vorteilhafte Montagemöglichkeiten und eine günstige Signalerfassung in Verbindung mit den Transpondern. Jedoch ist für die BenutzerInformation meist auch eine schnelle Erkennung der Einbausituation seiner Geräte vor Ort erwünscht.

Das Dokument US2004/0172155A1 offenbart einen Leuchtdioden aufweisenden Schaltschrank, wobei die Leuchtdioden den Einbaupositionen von Einbaugeräten zugeordnet sind und auf Basis von in einer zentralen Speichereinheit abgelegten Informationen angesteuert werden.

Der Erfindung liegt die Aufgabe zugrunde, einen Schaltschrank oder Rack der eingangs genannten Art bereitzustellen, die eine erweiterte Benutzerführung ergibt.

Diese Aufgabe wird mit den Merkmalen des Anspruches 1 gelöst.

Erfindungsgemäß ist die Überwachungs- und Steuerungseinrichtung zum Austeuern der Leuchtelemente ausgebildet, wobei die Leuchtelemente in Abhängigkeit von den an die Überwachungs- und Steuerungseinrichtung übertragenen Informationen der Transponderelemente gesteuert werden, und wobei die Leuchtelemente Leuchtdioden, wobei die Über-wachungs- und Steuerungseinrichtung auch zum Ansteuern der Leuchtdioden ausgebildet ist.

Mit diesen Maßnahmen wird dem Benutzer auch im Bereich des Schaltschranks oder Racks eine übersichtliche optische Information geboten.

Der Aufbau und die Ansteuerung der Leuchtelemente werden dadurch begünstigt, dass in der Detektorleiste angeordnete Datenleitungen und/oder Versorgungsleitungen zumindest zum Teil den Leuchtelementen und den Detektorelementen gemeinsam zugeordnet sind.

Verschiedenartige Informationen können dadurch dargestellt werden, dass die Leuchtelemente jeweils zur Abgabe von Licht unterschiedlicher Farbe und/oder zeitlicher Leuchtfrequenz ansteuerbar sind.

Zu einem vorteilhaften Aufbau und einer einfachen Montage tragen die Maßnahmen bei, dass die Detektorleiste einen Gehäusekörper mit einem Hohlprofil aufweist.

Dabei besteht eine vorteilhafte Ausgestaltung darin, dass das Hohlprofil quadratischen, rechteckförmigen, runden, C-förmigen oder U-förmigen Querschnitt aufweist und auf seiner im montierten Zustand vorderen Seite zumindest abschnittsweise vor den Leuchtelementen mit einem transparenten Abdeckteil versehen ist, und ferner darin, dass das im Querschnitt U-förmige Hohlprofil einen ebenen Basisschenkel mit rechtwinklig dazu ausgerichteten Seitenschenkeln aufweist, die im Querschnitt gesehen gleich lang, länger oder kürzer als der Basisschenkel sind.

Vorteile für den Aufbau und die Funktion ergeben sich auch dadurch, dass die Seitenschenkel auf ihrer Innenseite im Bereich ihrer freien Längsränder mit Haltenuten versehen sind, die sich mit ihrer Öffnungsseite gegenüberliegen und die das eingesetzte Abdeckteil entlang dessen Längsränder vorder- und rückseitig übergreifen.

Eine für die Funktion und die Integration vorteilhafte weitere Ausgestaltung der Erfassungseinrichtung wird dadurch erhalten, dass die Detektorleiste als Antennenleiste und die Detektorelemente als Antennenelemente ausgebildet sind und dass die Code-Träger als Transponderelemente, insbesondere RFID-Tags, ausgebildet sind.

Die Funktion und die Montage werden ferner dadurch begünstigt, dass die Befestigungsabschnitte flach ausgebildet sind und in einer frontseitigen Montageebene liegen, dass die Antennenleiste mit ihrer Frontseite in der Montageebene liegt oder gegenüber dieser um höchstens 10 mm zurückversetzt ist und dass der jeweilige Code-Träger vor der Frontseite der Detektorleiste angeordnet und auf einem die Detektorleiste überlappenden Tragabschnitt eines Halteelementes befestigt ist, das mit einem Verbindungsabschnitt an dem benachbarten Montageabschnitt der zugeordneten Einbaueinheit angebracht ist.

Zu einer vorteilhaften Benutzerführung tragen die Maßnahmen bei, dass die Leuchtelemente in Längsrichtung der Detektorleiste in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil positionsgenau sichtbar sind und/oder dass im Inneren der Antennenleiste im Raster einer Höheneinheit HE oder einem ganzzahligen Vielfachen oder gleichmäßigen Teilabstand davon in Längsrichtung der Antenneneinheit voneinander beabstandete Antennenelemente angeordnet sind.

Eine vorteilhafte, exakte Anordnung wird dadurch erhalten, dass das Montageprofil eine an den Querschnitt der Detektorleiste zumindest teilweise angepasste Aufnahme mit einem gegenüber der Montageebene zumindest um die Querschnittstiefe der Antennenleiste zurückversetzten Anlageabschnitt und mit einer die Aufnahme auf deren dem Einbauraum zugekehrter Seite begrenzenden innenseitigen Begrenzungswand aufweist, dass der Anlageabschnitt und die innenseitige Begrenzungswand im Querschnitt der Aufnahme rechtwinklig zueinander angeordnet sind, wobei der Anlageabschnitt parallel zur Montageebene ausgerichtet ist, und dass die Begrenzungswand über einen Übergangsabschnitt oder unmittelbar rechtwinklig in den Befestigungsabschnitt übergeht.

Eine für die Montage vorteilhafte Ausgestaltung besteht darin, dass in dem Anlageabschnitt eine Haltelochreihe mit in regelmäßigem Rasterabstand angeordneten Haltelöchern angeordnet ist, und dass die Haltelöcher quadratisch oder rechteckförmig mit in Längsrichtung des Montageprofils verlaufenden Längsseiten ausgebildet sind und dass die Detektorleiste auf ihrer dem Anlageabschnitt zugekehrten Rückseite mit Haltehaken versehen ist, die auf den Abstand der Haltelöcher oder ein Vielfaches davon abgestimmt sind und vertikale Hakenabschnitte aufweisen, die eine geringere Länge besitzen als die lichte Öffnungsweite der Haltelöcher in vertikaler Richtung und die soweit von der rückseitigen Außenfläche der Detektorleiste beabstandet sind, dass sie einen die Haltelöcher umgebenden Wandbereich des Anlageabschnitts mit einer Klemmkraft hintergreifen.

Der Aufbau und die Funktion werden auch dadurch begünstigt, dass das Halteelement flach ausgebildet ist und mit seinem Verbindungsabschnitt auf der ebenfalls flach ausgebildeten Rückseite des Montageabschnitts angeordnet und mit diesem gegen die Vorderseite des Befestigungsasbschnittes gedrückt ist und dass der Tragabschnitt sich in der Höhe über einen Bruchteil des Verbindungsabschnittes erstreckt.

Die Erfindung wird nachfolgend anhand von Ausführungsbeispielen unter Bezugnahme auf die Zeichnungen näher erläutert. Es zeigen:
- Fig. 1: eine frontseitige Montageebene eines Schaltschranks oder Racks,
- Fig. 2: einen Ausschnitt eines Einbauraums eines Schaltschranks oder Racks mit vorderer Montageebene und vertikalen Montageprofilen in perspektivischer Ansicht,
- Fig. 3: einen Ausschnitt der Montageebene im Bereich eines Montageabschnittes,
- Fig. 4: eine Detailansicht des Schaltschranks oder Racks in einem oberen vorderen Eckbereich des Einbauraums und der Montageebene mit mehreren eingesetzten Einbaueinheiten,
- Fig. 5: einen Ausschnitt des Schaltschranks oder Racks in einem oberen vorderen Eckbereich mit einer eingesetzten Antennenleiste und einem Halteelement mit Transponder in perspektivischer Ansicht,
- Fig. 6: einen Ausschnitt der Befestigungsebene im Bereich eines Montageabschnittes mit vertikalem Montageprofil, eingesetzter Antennenleiste und angebrachtem Halteelement mit Transponder,
- Fig. 7A bis 7C: eine perspektivische Ansicht, eine Vorderansicht und eine Ansicht auf die rückseitige Stirnseite eines Halteelementes mit Transponderelement,
- Fig. 8: eine perspektivische Ausschnittdarstellung des vorderen oberen Eckbereichs des Schaltschranks oder Racks mit einer Antennenleiste vor deren Einbau,
- Fig. 9A bis 9D: in Fig. 9A eine perspektivische Ansicht eines Abschnitts der Antennenleiste schräg auf die Rückseite; in den Teilbildern a), b) und c) der Fig. 9B die Antennenleiste von der Vorderseite, in einer seitlichen Ansicht und von der Rückseite; in Fig. 9C einen Längsschnitt der Antennenleiste sowie in Fig. 9D einen Querschnitt der Antennenleiste,
- Fig. 10: verschiedene Ansichten des vorderen Montagerahmens des Schaltschranks oder Racks mit seitlichen vertikalen Montageprofilen und einem unteren und oberen Rahmenschenkel sowie vergrößerten Ausschnittdarstellungen,
- Fig. 11: den vorderen Montagerahmen des Schaltschranks oder Racks in perspektivischer Ansicht,
- Fig. 12: einen Ausschnitt des Montagerahmens nach Fig. 11 im Verbindungsbereich zweier auseinander geschobener Leistenmodule,
- Fig. 13A: ein mit einer Detektorleiste im Bereich eines frontseitigen Montageprofils versehenes Rahmengestell eines Schaltschranks oder Racks und eine angeschlossene Überwachungs- und Steuerungseinrichtung,
- Fig. 13B: einen Ausschnitt des Rahmengestells in einem oberen Eckbereich mit einer anzubringenden Detektorleiste und darin angeordneten Leuchtelementen und Detektorelementen und
- Fig. 13C: ein Beispiel für eine Bildschirmdarstellung einer Einbauebene eines Schaltschranks oder Racks mit eingesetzten Einbaueinheiten in Form von Servereinheiten.

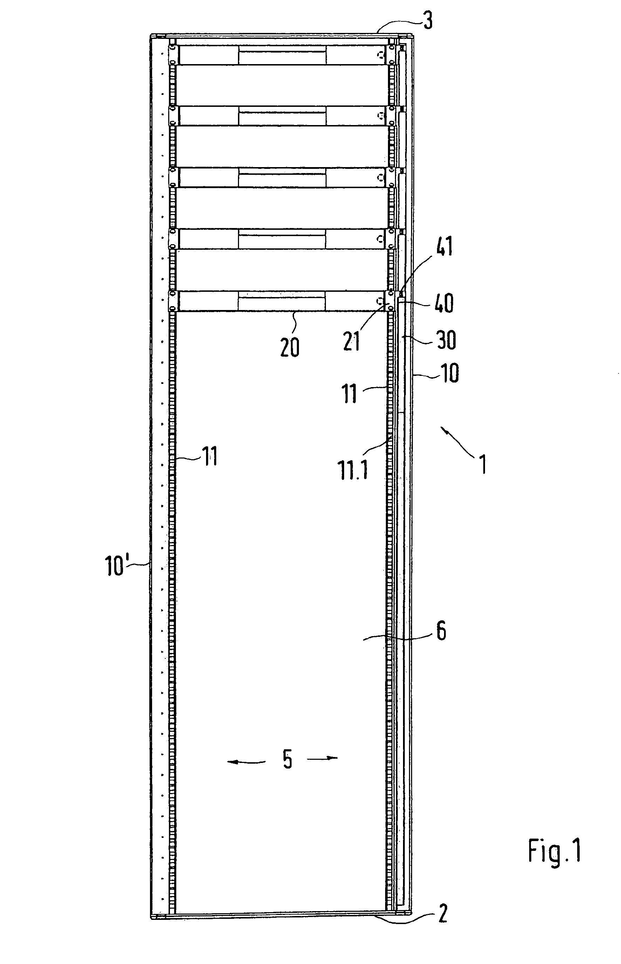

Fig. 1 zeigt eine vorderseitige Ansicht einer Montageebene 5 eines Rahmengestells 1 eines Schaltschranks oder Racks mit mehreren eingebauten Einbaueinheiten 20, wie z. B. Servereinheiten, deren Höhe beispielsweise eine HE beträgt. Die Montageebene 5 ist seitlich durch frontseitige Montageflächen zweier vertikaler Montageprofile 10, 10' und unten von einem unteren Rahmenschenkel 2 sowie oben von einem oberen Rahmenschenkel 3 begrenzt. An den die lichte Einbauöffnung begrenzenden Ränder der Montageprofile 10, 10' schließen sich beidseitig Befestigungsabschnitte 11 der Montageprofile mit Lochreihen 11.1 an, die einen engen Lochrasterabstand von vorliegend drei Befestigungslöchern pro Höheneinheit HE besitzen. Die Montageprofile 10, 10' können durch seitliche Rahmenprofile des Rahmengestells und/oder durch separate Montageprofile gebildet sein.

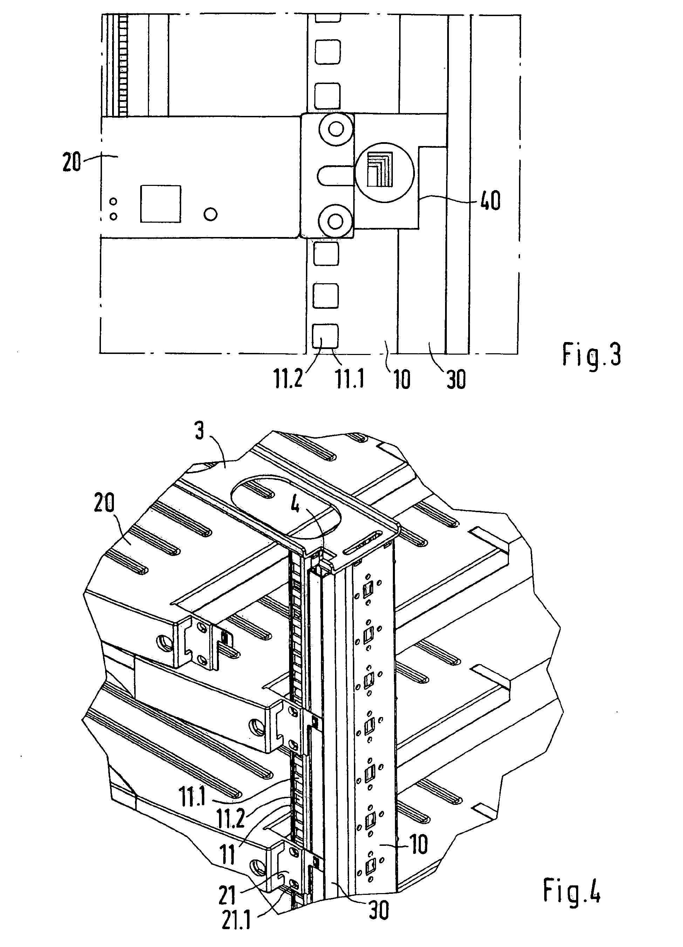

Die Einbaueinheiten 20 weisen seitlich abstehende flache Montageabschnitte 21 auf, die sich über die Gehäusehöhe der Einbaueinheiten 20, beispielsweise eine oder mehrere Höheneinheiten HE, erstrecken und über die beiderseitigen Befestigungsabschnitte 11 vorstehen. In den Montageabschnitten 21 sind z. B. jeweils zwei Montagelöcher 21.1 (vgl. z. B. auch Fig. 4) vorliegend im doppelten Abstand der Befestigungslöcher 11.2 der Lochreihe 11.1 eingebracht, so dass die Montagelöcher 21.1 jeweils ein Befestigungsloch 11.2 überspringen.

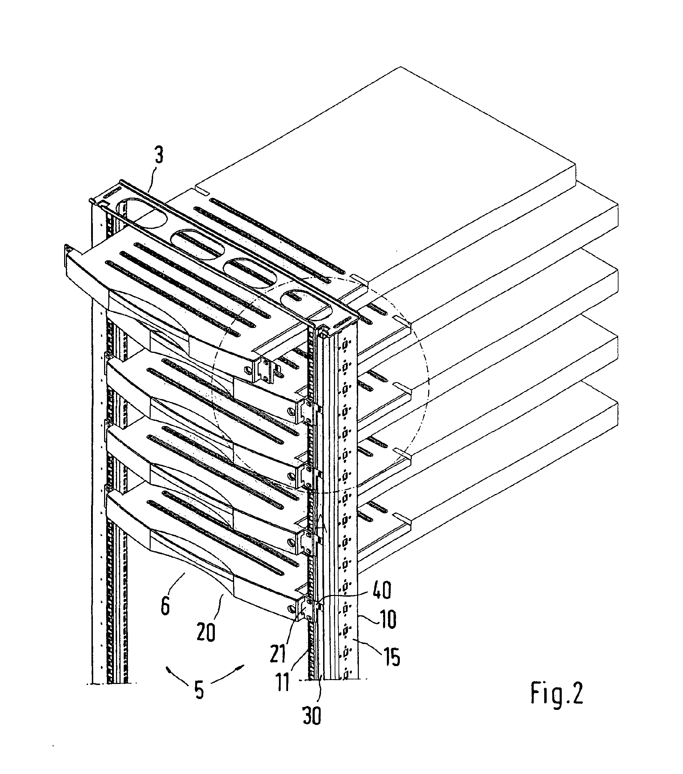

Im Bereich eines seitlichen Montageabschnittes, vorliegend des in Vorderansicht rechten Montageabschnittes 21, sind jeweils Halteelemente 40 angeordnet, beispielsweise an dem Montageabschnitt 21 festgeklebt oder zumindest zwischen diesem und dem Befestigungsabschnitt 11 eingeklemmt, wobei ein zungenartiger Tragabschnitt 41 mit einem darauf angebrachten Transponderelement 44 seitlich absteht und eine in dem Montageprofil 10 eingesetzte Antennenleiste 30 frontseitig überlappt, wie der Ausschnittsdarstellung nach Fig. 2 und den weiteren Darstellungen nach den Fig. 3, 4 und 5 deutlicher zu entnehmen ist.

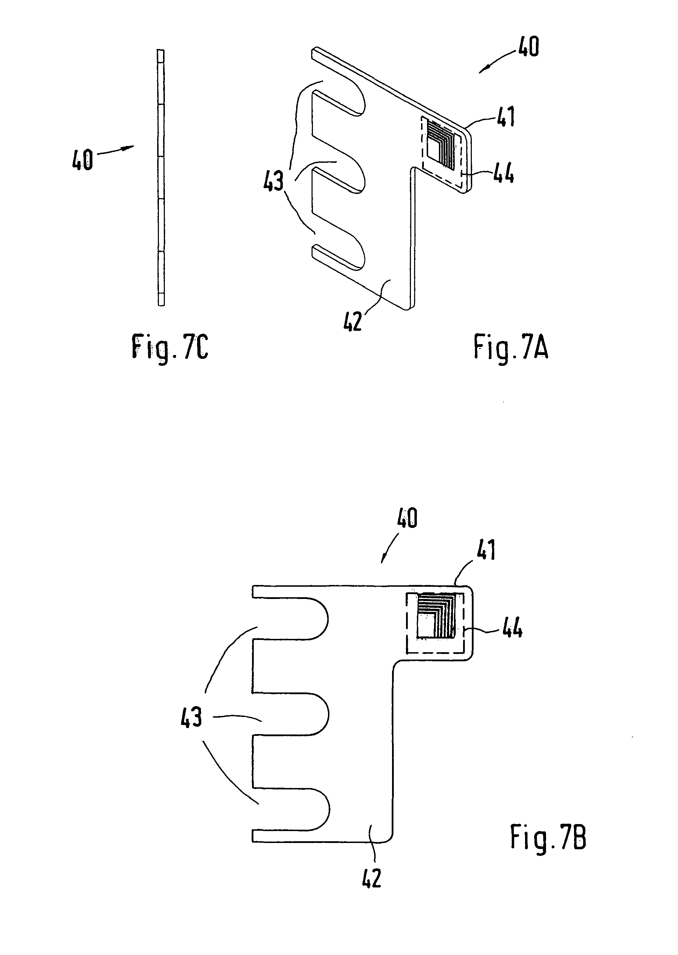

In den Fig. 7A, 7B, 7C ist das Halteelement 40 einzeln in verschiedenen Ansichten wiedergegeben. Die Halteelemente 40 sind aus flachem, plattenförmigem Material geringer Stärke von z. B. höchstens etwa 1 mm beispielsweise aus Metall oder Kunststoff hergestellt, vorzugsweise durch Stanzen oder Schneiden oder aber durch Formen. Das Halteelement 40 weist einen Verbindungsabschnitt 42 mit darin eingebrachten Öffnungen 43 auf, die zu dem von dem Tragabschnitt 41 abgelegenen Rand hin offen sind und eine portalförmige Kontur besitzen. Die im montierten Zustand vertikale Höhenausdehnung entspricht vorzugsweise der Höhe des Montageabschnitts 21, der in der Regel der Gehäusehöhe einer Einbaueinheit, also z. B. einer oder mehreren Höheneinheiten HE entspricht, während die seitliche Breitenausdehnung des Verbindungsabschnitts 42 in etwa der Breite des Montageabschnittes 21 entspricht, so dass im Montagezustand der außenseitige Rand des Verbindungsabschnitts 42 mit dem außenseitigen Rand des Montageabschnitts 21 in etwa bündig ist und auch der obere und untere Rand des Verbindungsabschnitts 42 und des Montageabschnittes 21 in etwa bündig sind. Der sich nur über einen Bruchteil, z. B. ½, 1/3, ¼ der Höhe des Verbindungsabschnitts 42 erstreckende Tragabschnitt 41, dessen oberer Rand beispielsweise in Verlängerung des oberen Randes des Verbindungsabschnittes verläuft, ist vorzugsweise lichtundurchlässig ausgebildet und trägt das darauf z. B. durch Kleben befestigte Transponderelement 44, insbesondere ausgebildet als RFID-Tag.

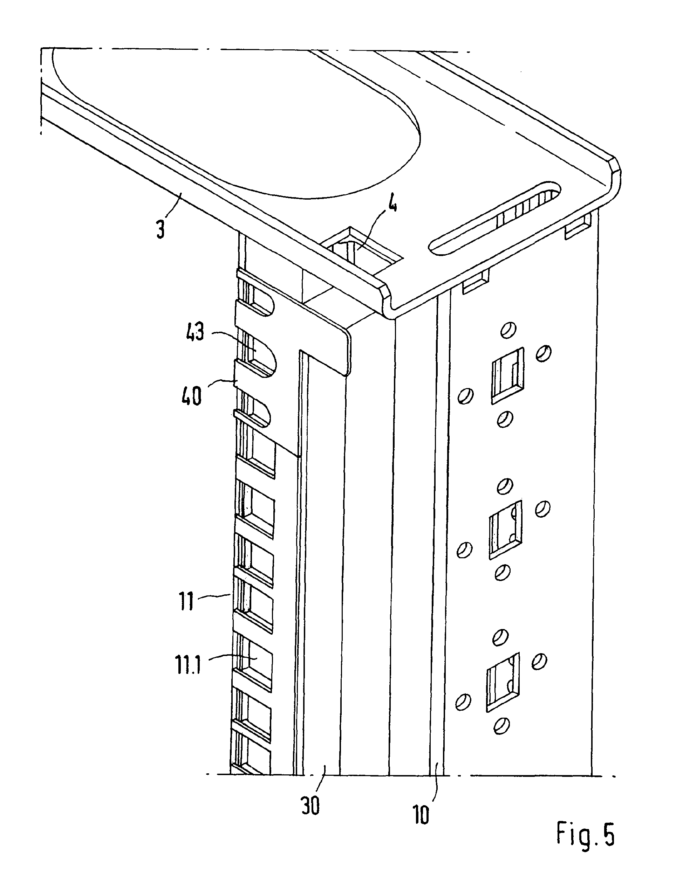

Wie Fig. 2 in perspektivischer Darstellung zeigt, sind die Halteelemente 40, die aus flachem blättchenförmigem Material beispielsweise aus Metall oder Kunststoff hergestellt sind, mit dem Verbindungsabschnitt 42 zwischen der flachen Rückseite des betreffenden Montageabschnittes 21 und der flachen Vorderseite des Befestigungsabschnittes 11 festgespannt, wobei sie zuvor vorteilhaft an dem jeweiligen Montageabschnitt 21 fixiert wurden, beispielsweise mittels einer auf ihnen angebrachten Klebeschicht, die im nicht angebrachten Zustand von einer ablösbaren Schutzfolie abgedeckt ist. In dem Verbindungsabschnitt 42 sind auf die Montagelöcher 21.1 in Lage und Größe abgestimmte Öffnungen 43 eingebracht, so dass die in den Einbauraum 6 eingesetzten und mit ihren Montageabschnitten 21 an den Befestigungsabschnitten 11 anliegenden Einbaueinheiten 20 mittels Schrauben oder ähnlichen Befestigungselementen ungehindert an den Befestigungsabschnitten 11 befestigt werden können, wie Fig. 3 zeigt. Wie ferner aus Fig. 5 ersichtlich, sind dabei auch die Öffnungen 43 der Verbindungsabschnitte 42 mit den betreffenden Befestigungslöchern 11.2 der Lochreihen 11.1 in Deckung gebracht.

Wie die Fig. 2 und insbesondere die vergrößerte Ausschnittsdarstellung nach Fig. 4 sowie auch die Fig. 5, 6 und 8 weiter zeigen, ist zumindest das in Draufsicht rechte Montageprofil, dem die Antennenleiste 30 zugeordnet ist, zur Außenseite an den betreffenden Befestigungsabschnitt 11 anschließend mit einer innenseitigen Begrenzungswand 13 einer Aufnahme 14 für die Antennenleiste 30 versehen. Die innenseitige Begrenzungswand 13 geht an ihrem von der Frontseite abliegenden rückseitigen Ende rechtwinklig in einen nach außen zeigenden Anlageabschnitt 12 in der Tiefe der Aufnahme 14 über, an die die Antennenleiste 30 beim Einsetzen in Anlage gebracht wird. Dabei ist die Vorderseite des Anlageabschnittes 12 von der frontseitigen Montageebene bzw. der Ebene des Befestigungsabschnittes 11 in einem solchen Abstand zurück versetzt, dass die Antennenleiste 30 mit ihrer Vorderseite nicht über die Frontebene des Befestigungsabschnittes 11 übersteht und vorzugsweise mit dieser bündig ist oder nur wenig, z. B. nicht mehr als 10 mm zurückversetzt ist. Besonders bei bündiger Anordnung der Vorderseite der Antennenleiste 30 in der vorderen Montageebene ist der Tragabschnitt 41, auf dessen Rückseite ein insbesondere als RFID-Tag ausgebildetes Transponderelement 44 angebracht ist und der die Frontseite der Antennenleiste 30 überlappt, in möglichst geringem Abstand zur Antennenleiste 30 und darin enthaltenen Antennenelementen angeordnet, so dass sich eine geringe Übertragungsdistanz für die Informationsübertragung zwischen Transponderelement 44 und dem betreffenden Antennenelement ergibt.

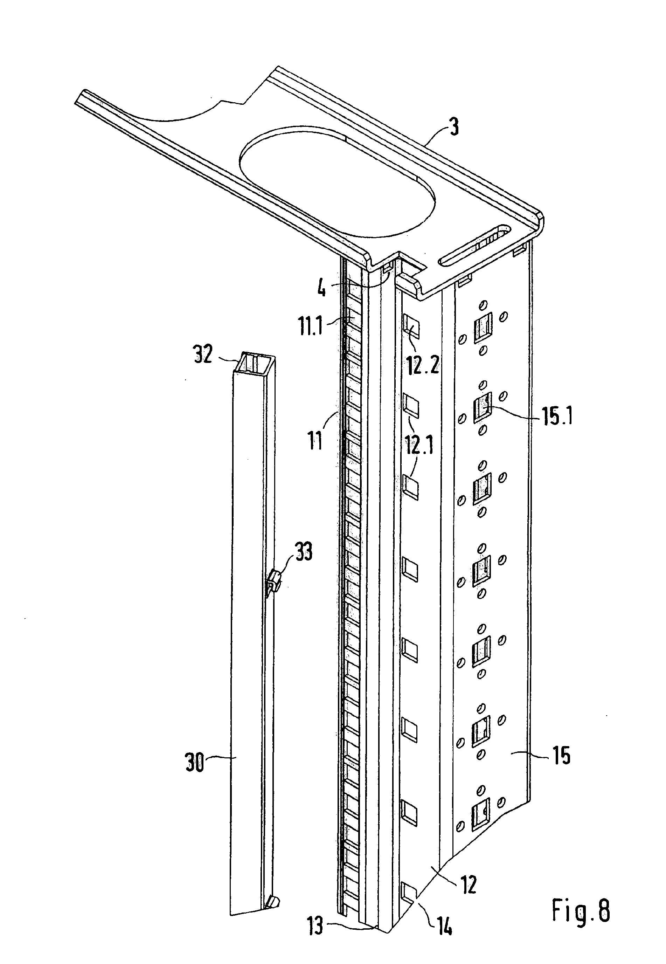

Wie aus Fig. 8 weiter ersichtlich, ist in dem Anlageabschnitt 12 eine Haltelochreihe 12.1 mit mindestens zwei Haltelöchern 12.2 eingebracht, die einen gleichmäßigen Lochrasterabstand in vertikaler Richtung aufweisen, beispielsweise im Abstand einer oder mehrerer Höheneinheiten. Die Haltelöcher 12.2 sind rechteckförmig oder quadratisch geformt und mit ihren Lochbegrenzungsseiten horizontal bzw. vertikal bezüglich der Längsrichtung des Montageprofils 10 bzw. 10' ausgerichtet. Die Antennenleiste 30 ist auf ihrer Rückseite mit Hakenelementen 33 versehen, die beispielsweise durch teilweises Ausstanzen und Ausbiegen aus deren Rückwand hergestellt sind, wobei nach unten gerichtete Hakennasen gebildet sind, die von der Rückwandebene der Antennenleiste 30 um etwas weniger als die Stärke der Wandung des Anlageabschnittes 12 um die Haltelöcher 12.2 beabstandet sind, wobei der nach unten gerichtete Abschnitt an seinem unteren Endabschnitt nach außen von der Rückwandebene der Antennenleiste 30 weggebogen ist, so dass sich ein einfaches Einhängen ergibt.

Der nach unten gerichtete Hakenabschnitt ist dabei kürzer als die vertikale Öffnungsweite der Haltelöcher 12.2. Über die Länge der Antennenleiste 30 sind mehrere derartige Hakenelemente angeordnet, die auf den Lochrasterabstand der Haltelöcher 12.2 oder ein Mehrfaches davon abgestimmt sind. Außerdem ist die Breite der Haken auf die Breite der Haltelöcher 12.2 derart abgestimmt, dass sie mit möglichst geringem seitlichem Spiel in die Haltelöcher 12.2 passen. Mit diesen Maßnahmen kann die Antennenleiste 30 einfach und lagegenau in die Aufnahme 14 eingesetzt und mit ihrer Rückseite in Anlage an die Vorderseite des Anlageabschnittes 12 gebracht und anschließend durch Verschieben nach unten fixiert werden, wobei die Haltehaken 33 eine leichte Klemmwirkung ergeben.

Wie Fig. 8 weiter zeigt, ist in dem oberen horizontalen Rahmenschenkel 3, der auch ein Montageschenkel sein kann, fluchtend bezüglich der eingesetzten Antennenleiste 30 eine Ausnehmung 4 eingebracht, die mindestens so groß ist wie der Außenquerschnitt der Antennenleiste 30, so dass diese auch dann ungehindert eingesetzt werden kann, wenn sie sich im eingesetzten Zustand bis in den Bereich des oberen Endes der vertikalen Montageprofils 10 bzw. 10' erstreckt, um auch die obere Einbauposition des Einbauraums 6 auszunutzen. Auf diese Weise kann die Antennenleiste 30 über das vertikale Rahmenprofil 10 bzw. 10' hinausstehend eingesetzt und dann nach unten verschoben werden, um sie zu fixieren.

Wie die Fig. 2, 4, 5 und 8 weiter zeigen, geht der Anlageabschnitt 12 an seinem außenseitigen Rand in einen außenseitigen Seitenwandabschnitt 15 des Montageprofils 10 bzw. 10' über, der nach hinten gerichtet ist, und in dem eine weitere vertikale Lochreihe 15.1 mit Löchern für Montagezwecke angeordnet ist. Die Aufnahme 14 könnte auch auf ihrer Außenseite mit einer weiteren Wand parallel zur innenseitigen Begrenzungswand 13 versehen sein, die mit ihrem vorderen Rand höchstens bis in die frontseitige Montageebene vorsteht.

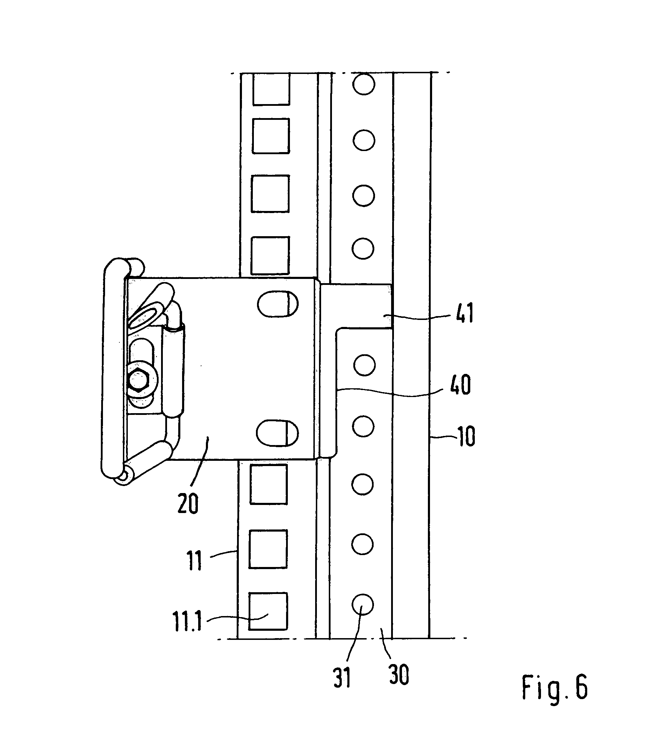

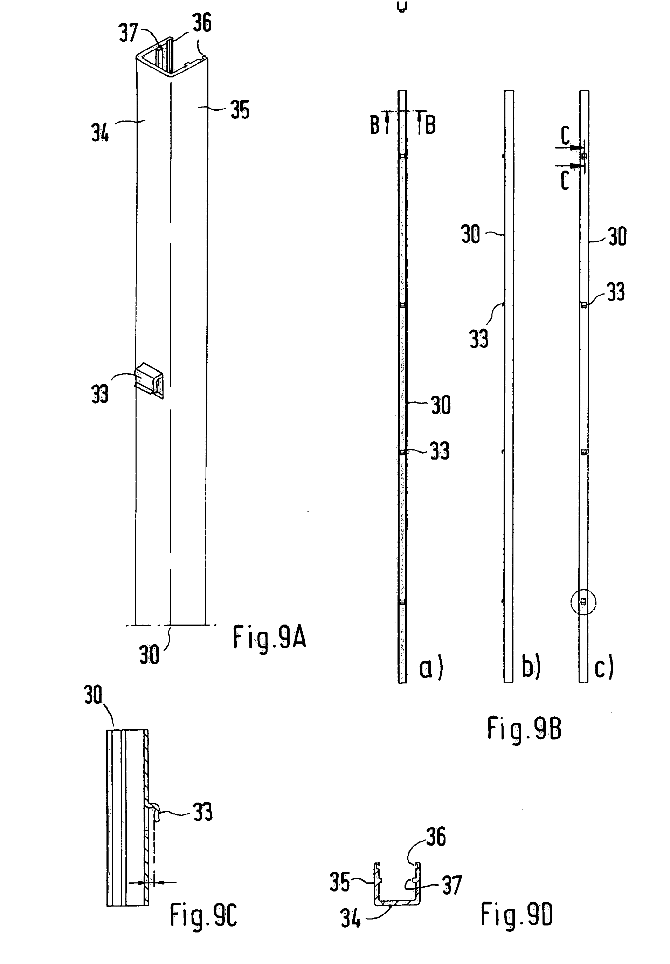

Wie Fig. 8 und weiterhin die Fig. 9A bis 9D zeigen, besitzt die Antennenleiste 30 ein Gehäuse mit U-förmigem, z. B. quadratischem oder rechtförmigem Querschnitt mit einem Basisschenkel 34 und zwei Seitenschenkeln 35. In die im eingebauten Zustand zur Frontseite des Schaltschranks bzw. Racks gerichtete vordere Seite ist ein Abdeckteil 32 eingesetzt, beispielsweise eingeschnappt oder eingerastet. Zum Halten des Abdeckteils 32 sind auf der Innenseite der Seitenschenkel 35 in der Nähe des freien Randes derselben längs verlaufende Haltenuten 36 ausgebildet, die die freien Ränder des vorzugsweise flachen Abdeckteils 32 vorderseitig und rückseitig überfassen. Das Abdeckteil 32 kann auch oder zusätzlich eingeklebt werden. Außerdem sind, gegenüber den Haltenuten 36 tiefer nach innen versetzt, auf der Innenseite der Seitenschenkel 35 sich gegenüberliegende Halterippen 37 eingebracht, so dass im Inneren des U-förmigen Gehäuses der Antennenleiste 30 weitere Elemente beispielsweise mittels Halteplättchen fixiert werden können, wie z. B. die genannten Antennenelemente und Zuführleitungen sowie auch später noch beschriebene Leuchtelemente 31 (vgl. Fig. 6). Das Abdeckteil 32 ist vorzugsweise lichtdurchlässig durchscheinend bzw. transparent ausgebildet, so dass Licht der Leuchtelemente 31 durchtritt, wobei die Leuchtelemente klar umgrenzt in ihrer Position individuell erkennbar sind, jedoch der Innenraum der Antennenleiste 30 vorzugsweise nicht einsehbar ist. Hierzu eignet sich entsprechend eingetrübtes Glas mit möglichst geringer Lichtschwächung und z. B. ohne selektive spektrale Filtereigenschaften.

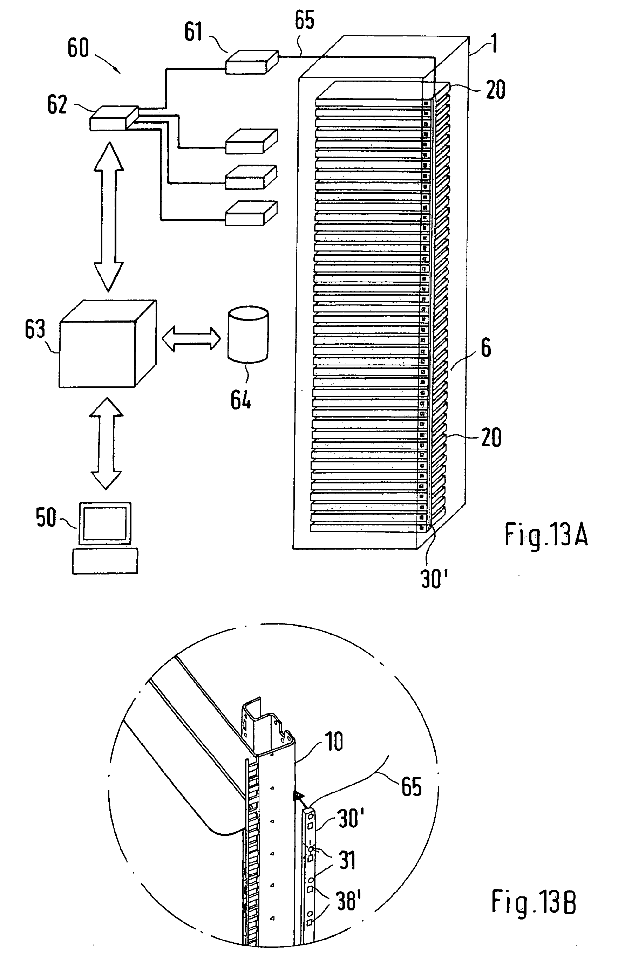

Wie Fig. 6 zeigt, sind die Leuchtelemente 31 ebenfalls in einem gleichmäßigen Rasterabstand über die Länge der Antennenleiste 30 angeordnet, wobei drei Leuchtelemente 31 pro Höheneinheit HE eingesetzt sind, aber auch z. B. zwei oder vier Leuchtelemente 31 pro Höheneinheit HE vorhanden sein können. Zwei der Leuchtelemente 31 liegen dabei neben dem Montageabschnitt 21 bzw. Verbindungsabschnitt 42 des Halteelementes 40 frei, und befinden sich bei eingesetzter Einbaueinheit 20 z. B. im angesteuerten leuchtenden Zustand, während ein drittes Leuchtelement 31 pro Höheneinheit bei eingesetzter Einbaueinheit 20 von dem vorzugsweise lichtundurchlässigen Tragabschnitt 41 des Halteelementes 40 abgedeckt ist, das sich in vertikaler Richtung vorliegend nur über etwa ein Drittel einer Höheneinheit HE erstreckt. Auf diese Weise werden einem Betrachter die Einbaulagen auch visuell gut erkennbar angezeigt, wobei besetzte Einbaupositionen leicht wahrnehmbar sind. Die Leuchtelemente 31 können über eine Steuereinheit 61, wie sie beispielsweise in Fig. 13A gezeigt und in der eingangs genannten DE 10 2007 034 437 A1 näher beschrieben ist, angesteuert werden, wobei verschiedene Ansteuerungsweisen in Frage kommen, z. B. in verschiedenen Farben unter Einsatz von verschiedenfarbig betreibbaren Leuchtdioden, oder in verschiedenen Blinkmodi bzw. im Dauerlichtbetrieb. Die Leuchtelemente 31 werden dabei in Abhängigkeit von den von den Transponderelementen 44 erhaltenen und über die Antennenelemente an die Steuereinheit 61 oder eine andere Stelle einer Überwachungs- und Steuerungseinrichtung 60 weitergeleiteten Informationen angesteuert. Die Detektorelemente 38' bzw. Antennenelemente können im selben Rasterabstand und in enger Nähe zu den Leuchtelementen 31 angeordnet sein, so dass sich eine eindeutige Informationserfassung und Positionszuordnung erreichen lässt. Weitere Signalisierungen können in Abhängigkeit von dem Betriebszustand der Einbaueinheiten, ihren in den Transponderelementen 44 z. B. werkseitig programmierten Eigenschaften und ihrer Einbaulage gesteuert werden, wobei die Steuereinheit 61 auch mit der übergeordneten Überwachungseinrichtung gegebenenfalls mit Registrierungseinrichtungen zusammenarbeiten kann.

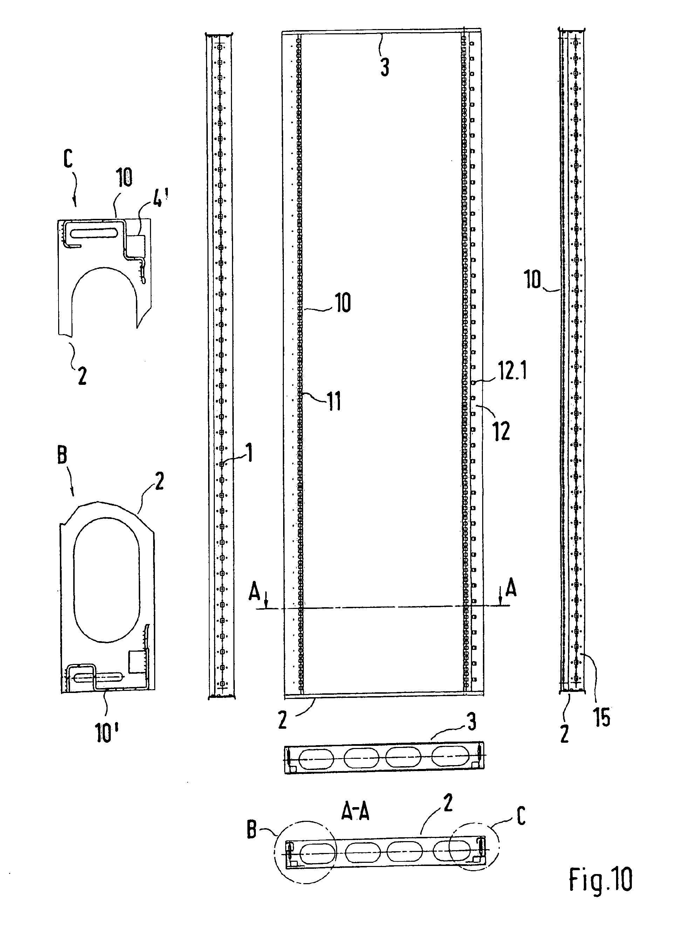

Wie Fig. 10 zeigt, kann auch in dem unteren Rahmenschenkel 2 eine Ausnehmung 4' zum Verschieben der Antennenleiste 30 nach unten eingebracht sein. Die beiden vertikalen Montageprofile 10, 10' können gleichen oder unterschiedlichen Aufbau aufweisen, wie die vergrößerten Ausschnitte B und C zeigen.

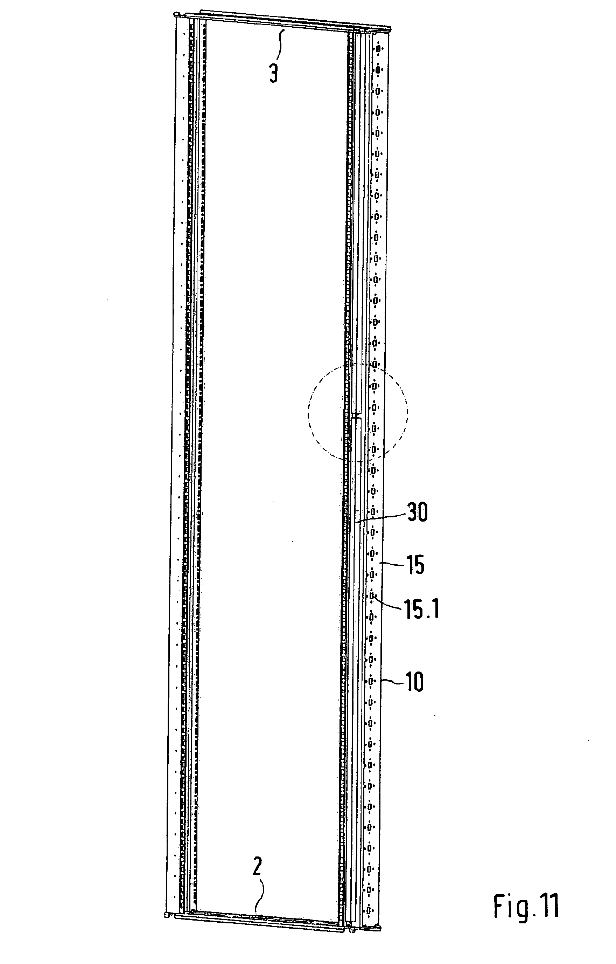

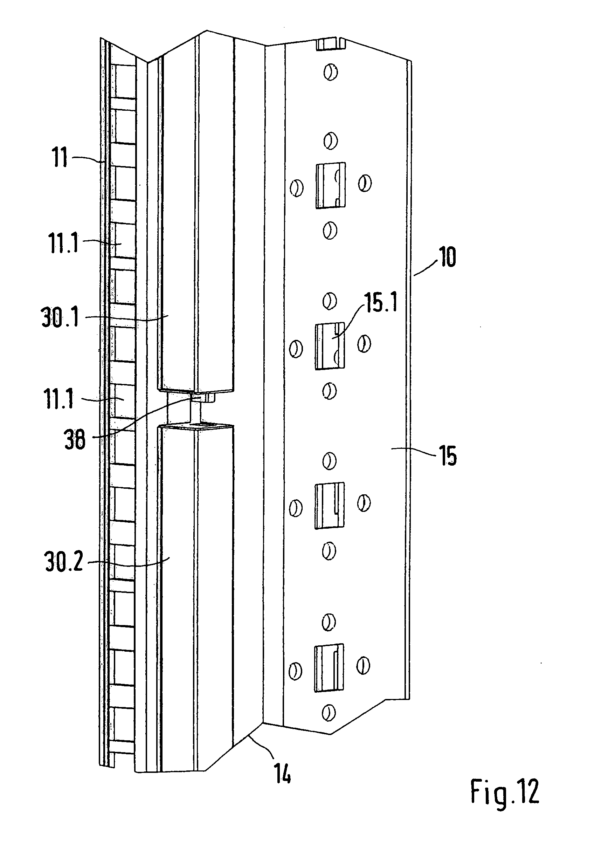

Wie die Fig. 11 und die vergrößerte Ausschnittdarstellung in Fig. 12 zeigen, kann die Antennenleiste 30 aus mehreren Leistenmodulen 30.1, 30.2 zusammengesetzt sein, die über eine Stecker-/Kupplungseinheit elektrisch leitend zusammengesteckt werden können, wobei sich auch eine mechanische Verbindung ergibt, die aber zusätzlich noch mittels Rastelementen oder anderen Steckelementen ergänzt sein kann.

Die Leistenmodule 30.1, 30.2 erstrecken sich vorzugsweise über mehrere Höheneinheiten und besitzen eine Länge, die auf verschiedene gängige Schaltschrankhöhen abgestimmt ist, so dass das kleinste Modul in einen Schaltschrank niedrigster Höhe passt und eine Antennenleiste 30 für einen höheren Schaltschrank durch Zusammenstecken mehrerer Leistenmodule 30.1, 30.2 erhalten wird.

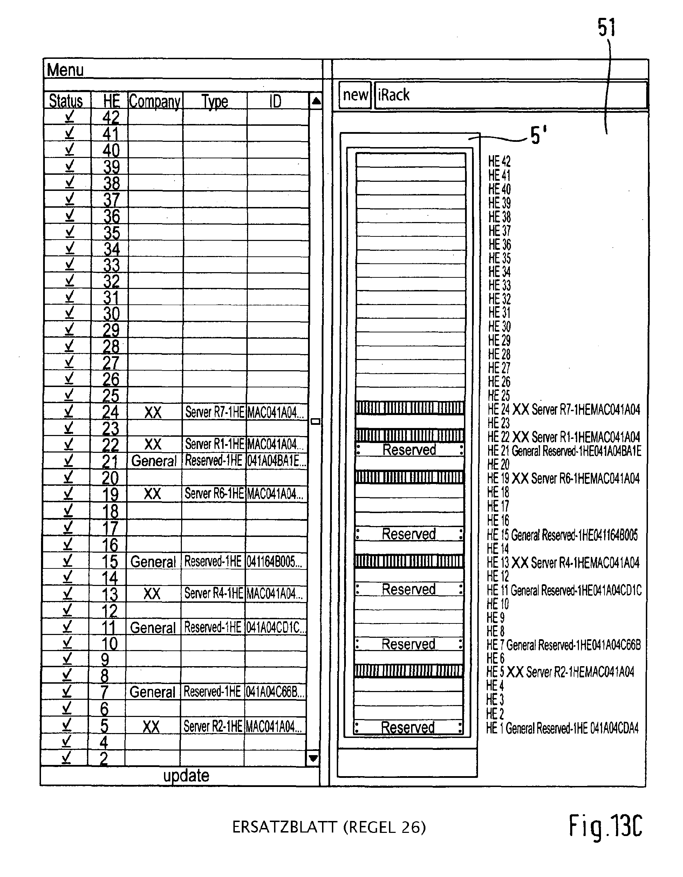

Fig. 13A zeigt einen Schaltschrank oder ein Rack mit einem schematisch dargestellten Rahmengestell 1 und an Einbaupositionen z. B. pro Höheneinheit HE in den Einbauraum 6 ragende Einbaueinheiten 20 z. B. in Form von Servereinheiten. Seitlich im vorderen Bereich des Rahmengestells im Bereich eines Rahmenprofils 10 ist eine Detektorleiste 30' in Längsrichtung des Montageprofils verlaufend angeordnet, die über eine Datenleitung 65 oder alternativ drahtlos mit einer Überwachungs- und Steuerungseinrichtung 60 in Datenübertragungsverbindung gebracht ist und von der Überwachungs- und Steuerungseinrichtung 60 auch mit Energie, z. B. über die Datenleitung 65 oder eine davon separate Versorgungsleitung, gespeist werden kann. Die Überwachungs- und Steuerungseinrichtung 60 weist eine Steuereinheit 61, eine mit dieser in Verbindung stehende Auswerteeinheit 62, eine Verwaltungseinrichtung 63 und eine Datenbankeinrichtung 64 auf und ist auch mit einer Anzeigestation mit einem Bildschirm 50 in Verbindung gebracht, um Bildschirmanzeigen 51 zu erzeugen, wie z. B. in Fig. 13C dargestellt. Mittels der Überwachungs- und Steuerungseinrichtung, beispielsweise der Steuereinheit 61 oder anderen Stellen der Überwachungs- und Steuerungseinrichtung 60, können Informationen, die von dem Transponderelement 44 oder einem anderen einer jeweiligen Einbaueinheit 20 zugeordneten Code-Träger erhalten und über die Antennenelemente oder andere Detektorelemente 38' weitergeleitet werden, registriert, verarbeitet und/oder ausgewertet werden. Mit diesen Informationen, die die Einbauposition einer jeweiligen Einbaueinheit 20 oder nicht besetzte Einbaupositionen des Schaltschranks oder Racks und/oder jeweilige Zustände der Einbaueinheiten 20 betreffen, können die Leuchtelemente 31 angesteuert werden, um eine optische Anzeige an der jeweiligen Einbauposition zu erzeugen. Die Energieversorgung der Leuchtelemente 31 kann dabei über die Datenleitung 65 oder ebenfalls über eine separate Versorgungsleitung erfolgen. Denkbar ist auch, die Leuchtelemente 31 über die jeweiligen benachbarten Detektorelemente 38' bzw. Antennenelemente unmittelbar anzusteuern, z. B. mittels Durchschaltens eines Halbleiterschaltglieds.

Die Ansteuerung der Leuchtelemente 31 kann z. B. so ausgelegt sein, dass Leuchtelemente neben unbesetzten Einbaupositionen dunkel gesteuert oder in einer anderen Farbe angesteuert sind als Leuchtelemente 31 neben besetzten Einbaupositionen. Die Kenntlichmachung von Einbaupositionen, aus denen z. B. für Wartungszwecke Einbaueinheiten 20 vorübergehend entnommen sind, kann z. B. durch Blinkbereich der zugeordneten Leuchtelemente 31 erfolgen.

Die Leuchtelemente 31 sind auf einer Platine montiert, die z. B. an den Rippen 37 angebracht ist. Auf der Platine oder einer weiteren Platine können auch die Datenleitungen und/oder die Versorgungsleitung(en) aufgebracht sein.

Fig. 13C zeigt ein Beispiel für eine Bildschirmanzeige 51 auf einem Bildschirm 50 einer entfernten Anzeigestation, wobei auf der Bildschirmanzeige 51 die Montageebene 5' eines Schaltschranks oder Racks mit seinen Höheneinheiten HE1 bis HE42 mit belegten Einbaupositionen dargestellt ist. Ferner sind neben der Einbauebene Zusatzinformationen zu den einzelnen Einbaueinheiten, beispielsweise Servereinheiten, eingeblendet, die den aktuellen Status und Eigenschaften der Einbaueinheiten 20 wiedergeben. Derartige Informationen können auf den Transponderelementen 44, insbesondere RFID-Tags, zum Teil gespeichert, zum anderen Teil in der Steuerungs- und Überwachungseinrichtung erzeugt werden und über die Antennenelemente und die Steuereinheit weitergeleitet werden. Auch können die auf den RFID-Tags enthaltenen und an die Steuereinheit, Registriereinrichtung bzw. übergeordnete Überwachungseinrichtung weitergeleiteten Informationen mit dort z. B. in der Datenbankeinrichtung 64 gespeicherten weiteren Informationen zu den Einbaueinheiten 20, wie z. B. technischen Daten, ergänzt werden.

## Patentansprüche

1. Schaltschrank oder Rack mit einer Montageeinrichtung, die einen Einbauraum (6) für anwenderseitige Einbaueinheiten (20) frontseitig seitlich begrenzende vertikale Montageprofile (10, 10') mit Befestigungsabschnitten (11) zum Anbringen von Montageabschnitten (21) der Einbaueinheiten (20) aufweist, und mit Komponenten einer Erfassungseinrichtung zum Feststellen, ob an einer Einbauposition des Einbauraums (6) eine Einbaueinheit (20) vorhanden ist oder nicht, wobei die Komponenten der Erfassungseinrichtung eine an einem Montageprofil (10) angebrachte vertikal verlaufende Detektorleiste (30) mit darauf oder darin angeordneten, den Einbaupositionen zugeordneten Detektorelementen (38') und an den Einbaueinheiten (20) angeordneten Transponderelementen (44) aufweisen, deren Information über die Detektorelemente (38') zur Auswertung an eine Überwachungs- und Steuerungseinrichtung (60) drahtlos oder drahtgebunden übertragbar ist, wobei
an oder in der Detektorleiste (30') Leuchtelemente (31) angebracht sind, die den Einbaupositionen zugeordnet sind,
die Leuchtelemente (31) in Abhängigkeit von den an die Überwachungs- und Steuerungseinrichtung (60) übertragenen Informationen der Transponderelemente (44) gesteuert werden, und
die Leuchtelemente (31) Leuchtdioden sind und die Überwachungs- und Steuerungseinrichtung (60) auch zum Ansteuern der Leuchtdioden ausgebildet ist.

2. Schaltschrank oder Rack nach Anspruch 1,
**dadurch gekennzeichnet,**
**dass** in der Detektorleiste (30') angeordnete Datenleitungen und/oder Versorgungsleitung zumindest zum Teil den Leuchtelementen (31) und den Detektorelementen (38') gemeinsam zugeordnet sind.

3. Schaltschrank oder Rack nach einem der vorhergehenden Ansprüche,
**dadurch gekennzeichnet,**
**dass** die Leuchtelemente (31) jeweils zur Abgabe von Licht unterschiedlicher Farbe und/oder zeitlicher Leuchtfrequenz ansteuerbar sind.

4. Schaltschrank oder Rack nach einem der vorhergehenden Ansprüche,
**dadurch gekennzeichnet,**
**dass** die Detektorleiste (30') einen Gehäusekörper mit einem Hohlprofil aufweist.

5. Schaltschrank oder Rack nach Anspruch 4,
**dadurch gekennzeichnet,**
**dass** das Hohlprofil quadratischen, rechteckförmigen, runden, C-förmigen oder U-förmigen Querschnitt aufweist und auf seiner im montierten Zustand vorderen Seite zumindest abschnittsweise vor den Leuchtelementen (31) mit einem transparenten Abdeckteil (32) versehen ist.

6. Schaltschrank oder Rack nach Anspruch 5,
**dadurch gekennzeichnet,**
**dass** das im Querschnitt U-förmige Hohlprofil einen ebenen Basisschenkel (34) mit rechtwinklig dazu ausgerichteten Seitenschenkeln (35) aufweist, die gleich lang, länger oder kürzer als der Basisschenkel (34) sind.

7. Schaltschrank oder Rack nach Anspruch 6,
**dadurch gekennzeichnet,**
**dass** die Seitenschenkel (35) auf ihrer Innenseite im Bereich ihrer freien Längsränder mit Haltenuten (36) versehen sind, die sich mit ihrer Öffnungsseite gegenüberliegen und die das eingesetzte Abdeckteil (32) entlang dessen Längsränder vorder- und rückseitig übergreifen.

8. Schaltschrank oder Rack nach einem der vorhergehenden Ansprüche,
**dadurch gekennzeichnet,**
**dass** die Detektorleiste (30') als Antennenleiste (30) und die Detektorelemente (38') als Antennenelemente ausgebildet sind und
**dass** die Transponderelemente (44) als RFID-Tags ausgebildet sind.

9. Schaltschrank oder Rack nach einem der vorhergehenden Ansprüche,
**dadurch gekennzeichnet,**
**dass** die Befestigungsabschnitte (11) flach ausgebildet sind und in einer frontseitigen Montageebene (5) liegen,
**dass** die Detektorleiste (30') mit ihrer Frontseite in der Montageebene (5) liegt oder gegenüber dieser um höchstens 10 mm zurückversetzt ist und
**dass** das jeweilige Transponderelement (44) vor der Frontseite der Detektorleiste (30') angeordnet und auf einem die Detektorleiste (30') überlappenden Tragabschnitt (41) eines Halteelementes (40) befestigt ist, das mit einem Verbindungsabschnitt (42) an dem benachbarten Montageabschnitt (21) der zugeordneten Einbaueinheit (20) angebracht ist.

10. Schaltschrank oder Rack nach Anspruch 9
**dadurch gekennzeichnet,**
**dass** die Leuchtelemente (31) in Längsrichtung der Detektorleiste (30') in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch ein transparentes Abdeckteil (30) positionsgenau sichtbar sind und
**dass** im Inneren der Detektorleiste (30') im Raster einer Höheneinheit HE oder einem ganzzahligen Vielfachen oder gleichmäßigen Teilabstand davon in Längsrichtung der Detektorleiste (30') voneinander beabstandete Detektorelemente angeordnet sind.

11. Schaltschrank oder Rack nach Anspruch 10,
**dadurch gekennzeichnet,**
**dass** das Montageprofil (10) eine an den Querschnitt der Detektorleiste (30') zumindest teilweise angepasste Aufnahme (14) mit einem gegenüber der Montageebene (5) zumindest und die Querschnittstiefe der Detektorleiste (30') zurückversetzten Anlageabschnitt (12) und mit einer die Aufnahme (14) auf deren dem Einbauraum (6) zugekehrter Seite begrenzenden innenseitigen Begrenzungswand (13) aufweist, dass der Anlageabschnitt (12) und die innenseitige Begrenzungswand (13) im Querschnitt der Aufnahme (14) rechtwinklig zueinander angeordnet sind, wobei der Anlageabschnitt (12) parallel zur Montageebene (5) ausgerichtet ist, und
**dass** die Begrenzungswand (13) über einen Übergangsabschnitt oder unmittelbar rechtwinklig in den Befestigungsabschnitt (11) übergeht.

12. Schaltschrank oder Rack nach Anspruch 11,
**dadurch gekennzeichnet,**
**dass** in dem Anlageabschnitt (12) eine Haltelochreihe (12.1) mit in regelmäßigem Rasterabstand angeordneten Haltelöchern (12.2) angeordnet ist, und dass die Haltelöcher (12.2) quadratisch oder rechteckförmig mit in Längsrichtung des Montageprofils (10) verlaufenden Längsseiten ausgebildet sind und dass die Detektorleiste (30') auf ihrer dem Anlageabschnitt (12) zugekehrten Rückseite mit Haltehaken (33) versehen ist, die auf den Abstand der Haltelöcher (12.2) oder ein Vielfaches davon abgestimmt sind und vertikale Hakenabschnitte aufweisen, die eine geringere Länge besitzen als die lichte Öffnungsweite der Haltelöcher (12.2) in vertikaler Richtung und die soweit von der rückseitigen Außenfläche der Detektorleiste (30') beabstandet sind, dass sie einen die Haltelöcher (12.2) umgebenden Wandbereich des Anlageabschnitts (12) mit einer Klemmkraft hintergreifen.

13. Schaltschrank oder Rack nach einem der Ansprüche 9 bis 12,
**dadurch gekennzeichnet,**
**dass** das Halteelement (40) flach ausgebildet ist und mit seinem Verbindungsabschnitt (42) auf der ebenfalls flach ausgebildeten Rückseite des Montageabschnitts (21) angeordnet und mit diesem gegen die Vorderseite des Befestigungsasbschnittes (11) gedrückt ist und
**dass** der Tragabschnitt (41) sich in der Höhe über einen Bruchteil des Verbindungsabschnittes (42) erstreckt.

## Claims

1. A switchgear cabinet or rack comprising a mounting unit, the front which has vertical m mounting profiles (10, 10') that laterally delimit an installation space (6) for installed user-side units (20), said profiles having fixing sections (11) for attaching mounting sections (21) of the installed units (20), and comprising components of a detection device for determining the presence of an installed unit (20) in an installation position of the installation space (6), wherein the components of the detection device have a vertical detector strip (30) that is attached to a mounting profile (10) and contains detector elements (38') associated with the installed positions and arranged on or in said strip and transponder elements (44) that are provided on the installed units (20), the information from said transponder elements being transmitted for evaluation via the detector elements (38') to a monitoring and control unit (60), either wirelessly or by wire, wherein illuminating elements (31) are mounted on or in the detector strip (30'), said elements being associated with the installation positions,
wherein the monitoring and control unit (60) is adapted for control of the illuminating elements (31),
wherein the illuminating elements (31) being controlled in accordance with the information of the transponder elements (44) transmitted to the monitoring and control unit (60), and
wherein said illuminating elements (31) are light emitting diodes and the monitoring and controlling unit (16) is also configured to drive said light emitting diodes.

2. The switchgear cabinet or rack of claim 1, **characterized in that** said illuminating elements (31) and said detector elements (38') at least partly share data lines and/or supply lines which are arranged in said detector strip (30').

3. The switchgear cabinet or rack of any of the preceding claims, **characterized in that** said illuminating elements (31) are respectively controllable for emitting light of different color and/or temporal illuminating frequency.

4. The switchgear cabinet or rack of any of the preceding claims, **characterized in that** said detector strip (30') comprises a housing body having a hollow profile.

5. The switchgear cabinet or rack of claim 4, **characterized in that** said hollow profile comprises a square, rectangular, round, C-shaped or U-shaped cross section and is provided on its front in a mounted state with a transparent cover part (32) at least in sections in front of said illuminating elements (31).

6. The switchgear cabinet or rack of claim 5, **characterized in that** said hollow profile having U-shaped cross section comprises a flat base leg (34) with perpendicularly oriented lateral legs (35) which are as long as, longer than or shorter than said base leg (34).

7. The switchgear cabinet or rack of claim 6, **characterized in that** said lateral legs (35) are provided with retaining grooves (36) on their inner side in the region of their exposed longitudinal edges which oppose each other with their opening faces and which forwardly and rearwardly engage behind the inserted cover part (32) along the longitudinal edges thereof.

8. The switchgear cabinet or rack of any of the preceding claims, **characterized in that** said detector strip (30') is configured as antenna strip (30) and said detector elements (38') are configured as antenna elements and said transponder elements (44) as RFID tags.

9. The switchgear cabinet or rack of any of the preceding claims, **characterized in that** said fixing sections (11) are flat and lie on a front face mounting plane (5), said antenna strip (30) lies with its front face on the mounting plane (5) or is set back in relation thereto by a maximum of 10 mm and the relevant transponder element (44) is arranged in front of the front side of said detector strip (30') and is attached on a support section (41) of a retaining element (40) overlapping said detector strip (30'), which element is attached to the neighboring mounting section (21) of the associated installed unit (20) via a connecting section (42).

10. The switchgear cabinet or rack of any of the preceding claims, **characterized in that** said illuminating elements (31) are arranged in longitudinal direction of said detector strip (30') in regular grid spacing within grid of a unit of height HE an integer multiple thereof or in regular partial spacing thereof, are individually controllable and are, in an illuminating state, accurately visible through a transparent cover part (30), and antenna elements, which are spaced in longitudinal direction of said antenna strip (30), are arranged in the interior of said antenna strip (30) within grid of a unit of height HE or an integer multiple thereof or in regular partial spacing thereof.

11. The switchgear cabinet or rack of claim 10, **characterized in that** said mounting profile (10) comprises a cavity (14) which is at least partly adapted to the cross section of said detector strip (30'), having an abutment section (12) which is set back in relation to the mounting plane (5) at least by the cross section depth of the antenna strip (30) and an inner boundary wall (13) delimiting said cavity (14) on its face facing the installation space (6), said abutment section (12) and said inner boundary wall (13) are arranged perpendicularly with respect to another in cross section of said cavity (14), wherein said abutment section (12) is aligned parallel to the mounting plane (5) and said boundary wall (13) merges perpendicularly into said fixing section (11) via an intermediate section or immediately.

12. The switchgear cabinet or rack of claim 11, **characterized in that** a row of retaining holes (12.1) is arranged in said bearing section (12) having retaining holes (12.2) arranged with regular grid spacing and said retaining holes (12.2) are square or rectangular with longitudinal sides running in longitudinal direction of said mounting profile (10) and said detector strip (30') being provided with retaining hooks (33) on its rear facing to said bearing section (12) which are harmonized to the spacing of the retaining holes (12.2) or a multiple thereof and comprise vertical hook sections which possess a smaller length than the clear opening width of the retaining holes (12.2) in a vertical direction and which are spaced from the rear outer face of the detector strip (30') so that they engage behind a wall section of the bearing section (12) surrounding said retaining holes (12.2).

13. The switchgear cabinet or rack of any of claims 9 to 12, **characterized in that** said retaining element (40) is flat and is arranged with its connecting section (42) on the rear of said mounting section (21) which is also flat and is pressed therewith against the front of the fixing section (11) and said support section (41) extends in its height over a fraction of the connecting section (42).

## Revendications

1. Armoire de commande ou rack avec un dispositif de montage, qui comprend un espace de montage (6) pour des unités de montage (20) côté utilisateur, des profilés de montage (10, 10') verticaux limités latéralement sur le côté avant avec des portions de fixation (11) pour la fixation de portions de montage (21) des unités d'installation (20) et avec des composants d'un dispositif de détection pour détecter si, à une position de montage de l'espace de montage (6), une unité de montage (20) est présente ou non, les composants du dispositif de détection comprenant une barre de détecteurs (30) verticale montée sur un profilé de montage (10) avec des éléments détecteurs (38'), disposés sur ou à l'intérieur de celle-ci, correspondant aux positions de montage, et des éléments transpondeurs (44) disposés sur les unités de montage (20), dont les informations concernant les éléments détecteurs (38') peuvent être transmises sans fil ou de manière filaire pour analyse à un dispositif de surveillance et de commande (60),
des éléments lumineux (31) étant montés dans la barre de détecteurs (30'), qui correspondent aux positions de montage,
les éléments lumineux (31) étant commandés en fonction des informations des éléments transpondeurs (44) transmises au dispositif de surveillance et de commande (60) et
les éléments lumineux (31) étant des diodes luminescentes et le dispositif de surveillance et de commande (60) étant également conçue pour la commande des diodes luminescentes.

2. Armoire de commande ou rack selon la revendication 1, **caractérisé en ce que**
les câbles de données et/ou le câble d'alimentation disposés dans la barre de détecteurs (30') correspondent au moins en partie aux éléments lumineux (31) et aux éléments détecteurs (38').

3. Armoire de commande ou rack selon l'une des revendications précédentes,
**caractérisé en ce que**
les éléments lumineux (31) peuvent être commandés pour l'émission de lumières de couleurs différentes et/ou de fréquences lumineuses différentes.

4. Armoire de commande ou rack selon l'une des revendications précédentes,
**caractérisé en ce que**
la barre de détecteurs (30') comprend un corps de boîtier avec un profilé creux ;

5. Armoire de commande ou rack selon la revendication 4,
**caractérisé en ce que**
le profilé creux présente une section transversale carrée, rectangulaire, ronde, en forme de C ou en forme de U et, sur son côté avant dans son état monté, est muni au moins sur certaines portions, devant les éléments lumineux (31), d'un élément de recouvrement transparent (32).

6. Armoire de commande ou rack selon la revendication 5,
**caractérisé en ce que**
le profilé creux de section transversale en forme de U comprend un montant de base plat (34) avec des montants latéraux (35) perpendiculaires qui sont de même longueur, plus longs ou plus courts que le montant de base (34).

7. Armoire de commande ou rack selon la revendication 6,
**caractérisé en ce que**
les montants latéraux (35) sont munis, sur leur côté intérieur, au niveau de leurs bords longitudinaux libres, de rainures de maintien (36) qui se font face avec leur côté ouvert et qui agrippent l'élément de recouvrement (32) utilisé le long de ses bords longitudinaux sur ses côtés avant et arrière.

8. Armoire de commande ou rack selon l'une des revendications précédentes,
**caractérisé en ce que**
la barre de détecteurs (30') est conçue comme une barre d'antennes (30) et les éléments détecteurs (38') sont conçus comme des éléments d'antennes et **en ce que** les éléments transpondeurs (44) sont conçus comme des balises RFID.

9. Armoire de commande ou rack selon l'une des revendications précédentes,
**caractérisé en ce que**
les portions de fixation (11) sont plates et se trouvent dans un plan de montage (5) du côté frontal,
**en ce que** la barre de détecteurs (30') se trouve, avec leur côté frontal, dans le plan de montage (5) ou en face de celui-ci décalé vers l'arrière de 10 mm au maximum et
**en ce que** l'élément transpondeur (44) correspondant se trouve devant le côté frontal de la barre de détecteurs (30') et est fixé sur une portion de support (41) de l'élément de maintien (40), se superposant avec la barre de détecteurs (30'), qui est monté avec une portion de liaison (42) sur la portion de montage (21) adjacente de l'unité de montage (20) correspondante.

10. Armoire de commande ou rack selon la revendication 9,
**caractérisé en ce que**
les éléments lumineux (31) sont disposés dans la direction longitudinale de la barre de détecteurs (30') avec une distance régulière entre eux dans la trame d'une unité de hauteur HE ou un multiple entier ou une distance partielle régulière, ils peuvent être commandés séparément et sont visibles avec une grande précision de position, dans leur état allumé, à travers un élément de recouvrement transparent (30) et
**en ce que**, à l'intérieur de la barre de détecteurs (30') sont disposés des éléments détecteurs distants entre eux dans une trame d'une unité de hauteur HE ou un multiple entier ou une distance partielle régulière dans la direction longitudinale de la barre de détecteurs (30').

11. Armoire de commande ou rack selon la revendication 10,
**caractérisé en ce que**
le profilé de montage (10) comprend un logement (14) au moins adapté partiellement à la section transversale de la barre de détecteurs (30') avec une portion d'appui (12) décalée vers l'arrière par rapport au plan de montage (5) à la profondeur de section transversale de la barre de détecteurs (30') et avec une paroi de limitation interne (13) limitant le logement (14) sur son côté orienté vers l'espace de montage (6),
**en ce que** la portion d'appui (12) et la paroi de limitation interne (13) sont disposées dans la section transversale du logement (14) de manière perpendiculaire entre elles, la portion d'appui (12) étant parallèle au plan de montage (5) et
**en ce que** la paroi de limitation (13) se transforme, par l'intermédiaire d'une portion de transition ou directement perpendiculairement, dans la portion de fixation (11).

12. Armoire de commande ou rack selon la revendication 11,
**caractérisé en ce que**
dans la portion d'appui (12), se trouve une série de trous de maintien (12.1) avec des trous de maintien (12.2) disposés à des intervalles réguliers et ce que les trous de maintien (12.2) sont munis de côtés longitudinaux s'étendant dans la direction longitudinale du profilé de montage (10), de manière carrée ou rectangulaire, et ce que la barre de détecteurs (30') sont munis, sur leur côté arrière orienté vers la portion d'appui (12), de crochets de maintien (33) qui sont adaptés à la distance des trous de maintien (12.2) ou à un multiple de celle-ci et qui présentent des portions de crochets verticales qui présentent une longueur inférieure à la largeur d'ouverture des trous de maintien (12.2) dans la direction verticale et qui sont éloignés de la surface externe arrière de la barre de détecteurs (30') de façon à ce qu'ils agrippent une partie de paroi de la portion d'appui (12) entourant les trous de maintien (12.2) avec une force de serrage.

13. Armoire de commande ou rack selon l'une des revendications 9 à 12,
**caractérisé en ce que**
l'élément de maintien (40) est plat et est disposé, avec sa portion de liaison (42) sur le côté arrière également plat de la portion de montage (21) et est comprimé avec celui-ci contre le côté avant de la portion de fixation (11) et **en ce que** la portion de support (41) s'étend en hauteur au-dessus d'une partie de la portion de liaison (42).
